# EUROPEAN PATENT APPLICATION

(11) **EP 3 315 891 A1**
(43) Date of publication of application: **02.05.2018**
(21) Application number: 17197732.5
(22) Date of filing: 23.10.2017
(51) Int. Cl.: F28F 21/02, F28F 13/18, H01L 23/367

(54) **ULTRA-LOW TEMPERATURE HEAT EXCHANGERS**

(30) Priority: 25.10.2016 US 201615334002
(71) Applicant: Honeywell International Inc., Morris Plains, NJ 07950 (US)
(72) Inventor: DORR, Joshua, Morris Plains, NJ New Jersey 07950 (US)
(74) Representative: Houghton, Mark Phillip

(57) **Abstract**

Ultra-low temperature heat exchangers, and methods of processing ultra-low temperature heat exchangers, are described herein. One apparatus includes a substrate, and a plurality of carbon nanotubes formed on the substrate, wherein the plurality of carbon nanotubes are formed on the substrate such that there is a space between each respective carbon nanotube into which a superfluid can wick, and the plurality of carbon nanotubes are configured to exchange heat with the superfluid that wicks in the space between each respective carbon nanotube.

## Description

### Technical Field

The present disclosure relates to ultra-low temperature heat exchangers, and methods of processing ultra-low temperature heat exchangers.

### Background

Ultra-low temperature cooling devices may use an ultra-low temperature (e.g., cryogenic) fluid and heat exchangers to provide cooling to ultra-low temperatures. For instance, ultra-low temperature cooling devices may be used to provide cooling to temperatures that are on the order of millikelvin (mK) or microkelvin. One example of such an ultra-low temperature cooling device is a dilution refrigerator.

The performance (e.g., cooling power and base temperature) of an ultra-low temperature cooling device may depend on the efficiency of its heat exchangers, and the efficiency of the heat exchangers may depend on thermal boundary resistance between the heat exchangers and the ultra-low temperature fluid. This resistance, which may be referred to as the Kapitza resistance, corresponds to the change in temperature due to heat flowing across the boundary of the heat exchanger and ultra-low temperature fluid.

As such, the lower the thermal boundary (e.g., Kapitza) resistance between the heat exchangers and the ultra-low temperature fluid, the better the performance of the ultra-low temperature cooling device. However, previous ultra-low temperature heat exchangers may have high thermal boundary resistances, which may limit the performance of previous ultra-low temperature cooling devices.

### Brief Description of the Drawings

Figure 1 illustrates an ultra-low temperature cooling device having an ultra-low temperature heat exchanger in accordance with one or more embodiments of the present disclosure.
Figure 2 illustrates an ultra-low temperature heat exchanger in accordance with one or more embodiments of the present disclosure.
Figure 3 illustrates a portion of an ultra-low temperature heat exchanger in accordance with one or more embodiments of the present disclosure.
Figure 4 illustrates a mixing chamber of an ultra-low temperature cooling device having a number of ultra-low temperature heat exchangers in accordance with one or more embodiments of the present disclosure.

### Detailed Description

Ultra-low temperature heat exchangers, and methods of processing ultra-low temperature heat exchangers, are described herein. For example, one or more embodiments include a substrate, and a plurality of carbon nanotubes formed on the substrate, wherein the plurality of carbon nanotubes are formed on the substrate such that there is a space between each respective carbon nanotube into which a superfluid can wick, and the plurality of carbon nanotubes are configured to exchange heat with the superfluid that wicks in the space between each respective carbon nanotube.

Ultra-low temperature heat exchangers in accordance with embodiments of the present disclosure can have a lower thermal boundary (e.g., Kapitza) resistance than previous heat exchangers. As such, ultra-low temperature cooling devices that utilize heat exchangers in accordance with the present disclosure can have better performance (e.g., lower boundary resistance) than cooling devices utilizing previous ultra-low temperature heat exchangers.

For example, previous ultra-low temperature heat exchangers may include sintered metallic (e.g., copper or silver) micro or nano powders that can be used to exchange heat with the ultra-low temperature fluid. However, such sintered metallic powders may have a lower specific surface area and/or a lower thermal conductivity than the carbon nanotubes used in the ultra-low temperature heat exchangers of the present disclosure. For instance, the sintered metallic powders of previous ultra-low temperature heat exchangers may have a specific surface area between 0.1 and 40 meters-squared per gram (m²/g), and may have a thermal conductivity of 385 Watts per meter-Kelvin (W/m•K) at room temperature. In contrast, the carbon nanotubes of the ultra-low temperature heat exchangers of the present disclosure may have a specific surface area of at least 1,000 m²/g, and may have a thermal conductivity of 3,500 W/m•K at room temperature. As a result, ultra-low temperature heat exchangers that utilize carbon nanotubes to exchange heat with an ultra-low temperature fluid in accordance with the present disclosure can have a lower thermal boundary (e.g., Kapitza) resistance than previous ultra-low temperature heat exchangers that utilize sintered metallic powers to exchange heat with the ultra-low temperature fluid.

In the following detailed description, reference is made to the accompanying drawings that form a part hereof. The drawings show by way of illustration how one or more embodiments of the disclosure may be practiced.

These embodiments are described in sufficient detail to enable those of ordinary skill in the art to practice one or more embodiments of this disclosure. It is to be understood that other embodiments may be utilized and that mechanical, electrical, and/or process changes may be made without departing from the scope of the present disclosure.

As will be appreciated, elements shown in the various embodiments herein can be added, exchanged, combined, and/or eliminated so as to provide a number of additional embodiments of the present disclosure. The proportion and the relative scale of the elements provided in the figures are intended to illustrate the embodiments of the present disclosure, and should not be taken in a limiting sense.

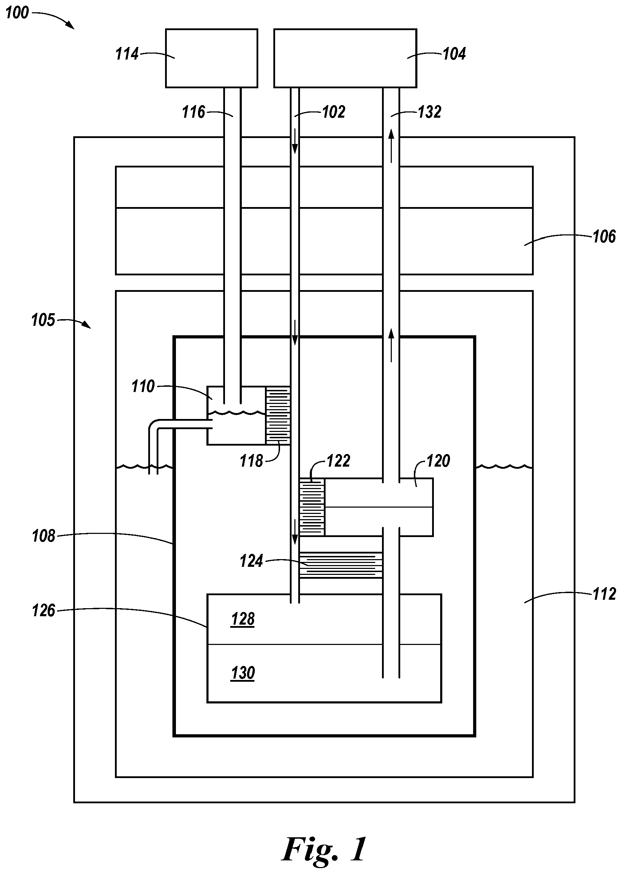

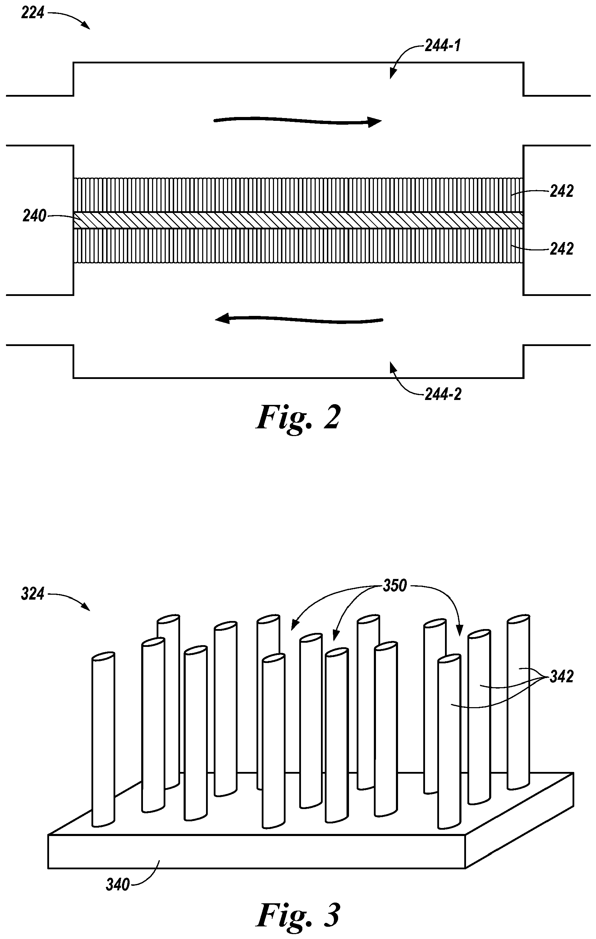

The figures herein follow a numbering convention in which the first digit or digits correspond to the drawing figure number and the remaining digits identify an element or component in the drawing. Similar elements or components between different figures may be identified by the use of similar digits. For example, 124 may reference element "24" in Figure 1, and a similar element may be references as 224 in Figure 2.

As used herein, "a" or "a number of" something can refer to one or more such things. For example, "a number of heat exchangers" can refer to one or more heat exchangers.

Figure 1 illustrates an ultra-low temperature cooling device 100 having an ultra-low temperature heat exchanger 124 in accordance with one or more embodiments of the present disclosure. As used herein, "ultra-low temperature" can refer to and/or include temperatures in the cryogenic regime, such as, for instance, temperatures on the order of millikelvin (mK). For instance, ultra-low temperature cooling device 100 can be a cryogenic device capable of providing cooling to temperatures on the order of mK using ultra-low temperature heat exchanger 124.

In the example illustrated in Figure 1, ultra-low temperature cooling device 100 is a dilution refrigerator (e.g., a wet dilution refrigerator). However, embodiments of the present disclosure not limited to a particular type of ultra-low temperature cooling device in which heat exchangers in accordance with the present disclosure can be included and/or used. For example, a heat exchanger or heat exchangers analogous to ultra-low temperature heat exchanger 124 can be included and/or used in a dry dilution refrigerator and/or an adiabatic demagnetization refrigerator, among other types of ultra-low temperature cooling devices.

In the example illustrated in Figure 1, ultra-low temperature cooling device 100 includes an ultra-low temperature fluid 102. Ultra-low temperature fluid 102 can be a cryogenic fluid, such as, for instance, a mixture of helium-3 (He-3) and helium-4 (He-4). During operation of ultra-low temperature cooling device 100, ultra-low temperature fluid 102 can circulate through device 100 and exchange heat with heat exchanger 124. For instance, during the circulation (e.g., cooling) cycle, the mixture may vary from room temperature gases (e.g., in the pumps of the device) to an ultra-low temperature fluid (e.g., at the lower stages of the device).

For example, ultra-low temperature cooling device 100 can include a circulating pump 104. As illustrated in Figure 1, circulating pump 104 can pump (e.g., via a return line) ultra-low temperature fluid 102 through liquid nitrogen 106 in a Dewar vacuum 105 of ultra-low temperature cooling device 100. Liquid nitrogen 106 can be at a temperature of 77 degrees Kelvin (K), and be used to precool and purify ultra-low temperature fluid 102.

As shown in Figure 1, ultra-low temperature fluid 102 can then enter vacuum chamber 108 of ultra-low temperature cooling device 100, which includes a 1 K pot (e.g., bath) 110 that can be used to further cool ultra-low temperature fluid 102 to a temperature of 1.2 to 1.5 K. For instance, the 1 K pot pump 114 can pump liquid He-4 from liquid He-4 reservoir 112 into 1 K pot 110 using pot pumping line 116. 1 K pot 110 (e.g., the liquid He-4 in pot 110) can liquefy ultra-low temperature fluid 102 (e.g., the He-3-He-4 mixture in fluid 102), and the resulting heat of condensation can be removed from ultra-low temperature fluid 102 by heat exchanger 118. Ultra-low temperature fluid 102 can then be further cooled to a temperature of 500 to 700 mK by still 120 (e.g., via still heat exchanger 122) of ultra-low temperature cooling device 100, which will be further described herein.

As shown in Figure 1, ultra-low temperature fluid 102 can then flow through a first flow channel (e.g., a first side) of ultra-low temperature heat exchanger 124, and enter mixing chamber 126 of ultra-low temperature cooling device 100. That is, ultra-low temperature heat exchanger 124 is outside of, and in fluid communication with, mixing chamber 126, as illustrated in Figure 1. Ultra-low temperature heat exchanger 124 will be further described herein (e.g., in connection with Figures 2-3).

Further, although one (e.g., a single) ultra-low temperature heat exchanger 124 is shown in the example illustrated in Figure 1, embodiments of the present disclosure are not so limited. For example, in some embodiments, ultra-low temperature cooling device 100 can include a number (e.g., plurality) of ultra-low temperature heat exchangers analogous to ultra-low temperature heat exchanger 124 that are in series, and outside of and in fluid communication with mixing chamber 126. In such embodiments, ultra-low temperature fluid 102 can flow through a first flow channel of each respective ultra-low temperature heat exchanger in the series, and then enter mixing chamber 126.

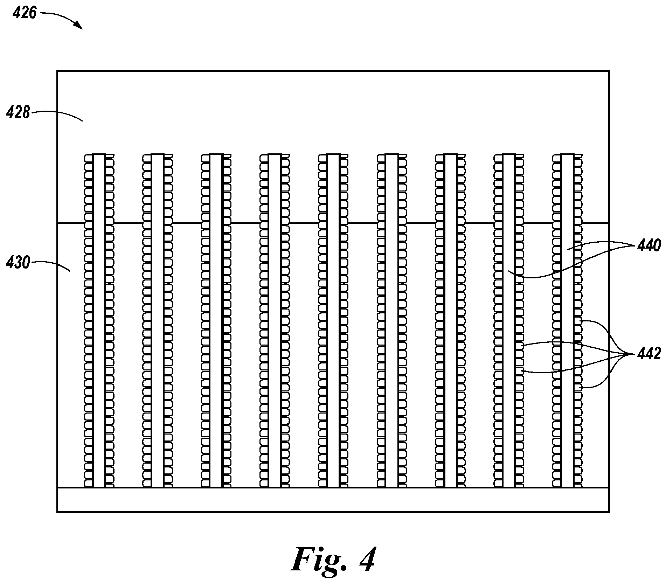

After ultra-low temperature fluid 102 has flowed through the first flow channel of ultra-low temperature heat exchanger 124 and entered mixing chamber 126, it has been cooled sufficiently such that (e.g., to a temperature at which) it undergoes a spontaneous phase separation to form a concentrated phase 128 and a dilute phase 130, as illustrated in Figure 1. Concentrated phase 128 can be an He-3 rich phase that is essentially pure (e.g., approximately 100%) He-3, and dilute phase 130 can be an He-3 poor phase that is approximately 6.6% He-3 and 93.4% He-4, for example. Concentrated phase 128 and dilute phase 130 of ultra-low temperature fluid 102 can be in equilibrium and separated by a phase boundary in mixing chamber 126, as illustrated in Figure 1. In some embodiments, mixing chamber 126 may also include a number of ultra-low temperature heat exchangers in accordance with embodiments of the present disclosure, as will be further described herein (e.g., in connection with Figure 4).

In mixing chamber 126, the He-3 of ultra-low temperature fluid 102 is diluted as it flows from concentrated phase 128 through the phase boundary and into dilute phase 130. The heat needed for this dilution provides the cooling power of ultra-low temperature cooling device 100, because moving the He-3 through the phase boundary is an endothermic process that removes heat from mixing chamber 126. The He-3 then exits mixing chamber 126 while in dilute phase 130, as illustrated in Figure 1.

After the diluted, cold He-3 exits mixing chamber 126, it can then flow through a second flow channel (e.g., a second side) of ultra-low temperature heat exchanger 124, as illustrated in Figure 1. As the diluted, cold He-3 flows through the second flow channel of ultra-low temperature heat exchanger 124, it can cool the ultra-low temperature fluid 102 that is flowing through the first flow channel of ultra-low temperature heat exchanger, as will be further described herein (e.g., in connection with Figure 2).

After the diluted He-3 flows through the second flow channel of ultra-low temperature heat exchanger 124, it can enter still 120, as illustrated in Figure 1. For instance, circulating pump 104 can pump He-3, which can create an osmotic pressure difference that can drive He-3 from concentrated phase 128 to dilute phase 130 in mixing chamber 126, and then up from mixing chamber 126 through the second flow channel ultra-low temperature heat exchanger 124 and into still 120. Still 120 can include superfluid He-4, through which the diluted He-3 can flow to create a mixture of He-3 and He-4, which can be pumped out of still 120 through still pumping line 132 and fed back into the return line via circulating pump 104, completing the circulation cycle of ultra-low temperature fluid 102.

Figure 2 illustrates an ultra-low temperature heat exchanger 224 in accordance with one or more embodiments of the present disclosure. Ultra-low temperature heat exchanger 224 can be, for instance, ultra-low temperature heat exchanger 124 of ultra-low temperature cooling device 100 previously described in connection with Figure 1.

As shown in Figure 2, ultra-low temperature heat exchanger 224 can include a substrate 240, and a plurality of carbon nanotubes 242 formed (e.g., grown) on substrate 240. For instance, in the example illustrated in Figure 2, a first number of the plurality of carbon nanotubes 242 are formed on a first surface (e.g., a first side) of substrate 240, and a second number of the plurality of carbon nanotubes 242 are formed on a second surface (e.g., a second side) of substrate 240 that is opposite the first surface. After the plurality of carbon nanotubes 242 are formed on substrate 240, ultra-low temperature heat exchanger 224 can be sealed and installed in an ultra-low temperature cooling device (e.g., ultra-low temperature cooling device 100).

Substrate 240 can comprise a metal material, such as, for instance, copper or silver. Each respective carbon nanotube 242 can comprise a non-metallic carbon based material, such as, for instance, an epoxy or plastic material.

In the example illustrated in Figure 2, the plurality of carbon nanotubes 242 are formed directly on substrate 240, such that the plurality of carbon nanotubes 242 are in direct contact with (e.g., bonded to) substrate 240. However, embodiments of the present disclosure are not so limited. For example, in some embodiments, a graphene material may be formed on substrate 240, and the plurality of carbon nanotubes 242 may be formed on the graphene material on substrate 240. This can be grown as a single structure, without grain boundaries.

As shown in Figure 2, ultra-low temperature heat exchanger 224 can include a first flow channel 244-1 adjacent to the first number of the plurality of carbon nanotubes 242 that are formed on the first surface of substrate 240, and a second flow channel 244-2 adjacent to the second number of the plurality of carbon nanotubes 242 that are formed on the second surface of substrate 240. For instance, flow channel 244-1 can be designed around the first side of substrate 240, and flow channel 244-2 can be designed around the second side of substrate 240.

The plurality of carbon nanotubes 242 can be formed on substrate 240 such that there is a space between each respective carbon nanotube 242 into which a superfluid of an ultra-low temperature fluid can wick (e.g., flow without the assistance of an external force). For instance, the plurality of carbon nanotubes 242 can be formed on substrate 240 such that they have feature size on the order of nanometers, into which the superfluid is capable of wicking. This space will be further illustrated in Figure 3.

The ultra-low temperature fluid can be, for example, ultra-low temperature fluid 102 previously described in connection with Figure 1. For instance, the superfluid of the ultra-low temperature fluid can be superfluid He-4 and/or superfluid He-3 (e.g., the superfluid form of the He-4 and/or He-3) of ultra-low temperature fluid 102.

The plurality of carbon nanotubes 242 can exchange heat with the superfluid (e.g., He-4 and/or He-3) of the ultra-low temperature fluid that wicks in the space between each respective carbon nanotube 242. For instance, as the superfluid of the ultra-low temperature fluid wicks in the space between each respective carbon nanotube 242, heat can flow from the superfluid to the plurality of carbon nanotubes 242, and then from the carbon nanotubes to substrate 240.

As such, the plurality of carbon nanotubes 242 (e.g., the first number of the carbon nanotubes formed on the first surface of substrate 240 and the second number of the carbon nanotubes formed on the second surface of substrate 240) can exchange between an ultra-low temperature fluid in (e.g., flowing through) the respective flow channels 244-1 and 244-2. As an example, with reference to Figure 1, flow channel 244-1 can be the first flow channel through which ultra-low temperature fluid 102 flows after being cooled by still 120 and before entering mixing chamber 126, and flow channel 244-2 can be the second flow channel through which the diluted, cold He-3 of the ultra-low temperature fluid flows after exiting mixing chamber 126 and before entering still 120. In such an example, the diluted, cold He-3 flowing through flow channel 244-2 can cool the second number of carbon nanotubes 242 that are adjacent flow channel 244-2, which in turn can cool substrate 240, which in turn can cool the first number of carbon nanotubes 242 that are adjacent flow channel 244-1, which in turn can cool the ultra-low temperature fluid flowing through flow channel 244-1.

Each respective carbon nanotube 242 formed on substrate 240 can have a specific surface area of at least 1,000 m²/g. Because the superfluid of the ultra-low temperature fluid can wick in the space between each respective carbon nanotube 242, this high specific surface area of the carbon nanotubes can be taken advantage of to decrease the thermal boundary (e.g., Kapitza) resistance, and therefore increase the performance, of ultra-low temperature heat exchanger 224 as compared to previous ultra-low temperature heat exchangers that utilize sintered metallic powers to exchange heat with ultra-low temperature fluid, as previously described herein.

Figure 3 illustrates a portion of an ultra-low temperature heat exchanger 324 in accordance with one or more embodiments of the present disclosure. The portion of ultra-low temperature heat exchanger 324 illustrated in Figure 3 can be, for example, a close-up view of a portion of ultra-low temperature heat exchanger 224 previously described in connection with Figure 2.

As shown in Figure 3, ultra-low temperature heat exchanger 324 can include a substrate 340, and a plurality of carbon nanotubes 342 formed on substrate 340. Substrate 340 and the plurality of carbon nanotubes 342 can be analogous to substrate 240 and the plurality of carbon nanotubes 242, respectively, previously described in connection with Figure 2.

Further, the plurality of carbon nanotubes 342 can be formed on substrate 340 in a manner analogous to that previously described in connection with Figure 2. For example, the plurality of carbon nanotubes 342 can be formed on substrate 340 such that there is a space 350 between each respective carbon nanotube 342 into which a superfluid (e.g., He-4 and/or He-3) of an ultra-low temperature fluid can wick (e.g., flow without the assistance of an external force). For instance, the amount (e.g., size) of space 350 between each respective carbon nanotube 342 illustrated in Figure 3 (e.g., the feature size of the carbon nanotubes 342) can be on the order of nanometers, which can be enough space for the superfluid to wick into.

The plurality of carbon nanotubes 342 can exchange heat with the superfluid of the ultra-low temperature fluid that wicks in the space 350 between each respective carbon nanotube 342, in a manner analogous to that previously described in connection with Figure 2. Because the superfluid can wick in the space 350 between each respective carbon nanotube 342, the high specific surface area of the carbon nanotubes can be taken advantage of to increase the performance (e.g., reduce the Kapitza resistance) of ultra-low temperature heat exchanger 324, as previously described herein.

Figure 4 illustrates a mixing chamber 426 of an ultra-low temperature cooling device having a number of ultra-low temperature heat exchangers in accordance with one or more embodiments of the present disclosure. Mixing chamber 426 can be, for example, mixing chamber 126 of ultra-low temperature cooling device 100 previously described in connection with Figure 1.

For instance, as shown in Figure 4, mixing chamber 426 can include a concentrated phase 428 and dilute phase 430 of an ultra-low temperature fluid in equilibrium and separated by a phase boundary. Concentrated phase 428 and dilute phase 430 can be, for example, concentrated phase 128 and dilute phase 130, respectively, of ultra-low temperature fluid 102 described in connection with Figure 1.

As shown in Figure 4, mixing chamber 426 can include a number of ultra-low temperature heat exchangers analogous to ultra-low temperature heat exchangers 124, 224, and/or 324 previously described in connection with Figures 1, 2, and 3, respectively. For example, each respective ultra-low temperature heat exchanger can include a substrate 440, and a plurality of carbon nanotubes 442 formed on substrate 440, as illustrated in Figure 4.

Substrate 440 and the plurality of carbon nanotubes 442 can be analogous to substrates 240 and/or 340, and the plurality of carbon nanotubes 242 and/or 342, respectively, previously described in connection with Figures 2 and 3. Further, the plurality of carbon nanotubes 442 can be formed in substrate 440, and used to exchange heat with the ultra-low temperature fluid in mixing chamber 426, in a manner analogous to that previously described herein.

Although specific embodiments have been illustrated and described herein, those of ordinary skill in the art will appreciate that any arrangement calculated to achieve the same techniques can be substituted for the specific embodiments shown. This disclosure is intended to cover any and all adaptations or variations of various embodiments of the disclosure.

It is to be understood that the above description has been made in an illustrative fashion, and not a restrictive one. Combination of the above embodiments, and other embodiments not specifically described herein will be apparent to those of skill in the art upon reviewing the above description.

The scope of the various embodiments of the disclosure includes any other applications in which the above structures and methods are used. Therefore, the scope of various embodiments of the disclosure should be determined with reference to the appended claims, along with the full range of equivalents to which such claims are entitled.

In the foregoing Detailed Description, various features are grouped together in example embodiments illustrated in the figures for the purpose of streamlining the disclosure. This method of disclosure is not to be interpreted as reflecting an intention that the embodiments of the disclosure require more features than are expressly recited in each claim.

The terms 'wicks' and 'to wick' can be exemplified by the condition of flowing without the assistance of an external force but is definable as - to absorb or draw off (a liquid) by capillary action. Wicking is capillary action. In this sense the wicking fluids of the present invention are acting as liquids.

Rather, as the following claims reflect, inventive subject matter lies in less than all features of a single disclosed embodiment. Thus, the following claims are hereby incorporated into the Detailed Description, with each claim standing on its own as a separate embodiment.

## Claims

1. An ultra-low temperature heat exchanger (124, 224, 324), comprising:
a substrate (240, 340); and
a plurality of carbon nanotubes (242, 342) formed on the substrate (240, 340), wherein:
the plurality of carbon nanotubes (242, 342) are formed on the substrate (240, 340) such that there is a space (350) between each respective carbon nanotube (242, 342) into which a superfluid can wick; and
the plurality of carbon nanotubes (242, 342) are configured to exchange heat with the superfluid that wicks in the space (350) between each respective carbon nanotube (242, 342).

2. The ultra-low temperature heat exchanger (124, 224, 324) of claim 1, wherein:
a first number of the plurality of carbon nanotubes (242, 342) are formed on a first surface of the substrate (240, 340); and
a second number of the plurality of carbon nanotubes (242, 342) are formed on a second surface of the substrate (240, 340) that is opposite the first surface.

3. The ultra-low temperature heat exchanger (124, 224, 324) of claim 2, wherein the ultra-low temperature heat exchanger (124, 224, 324) includes:
a first flow channel (244-1) adjacent to the first number of the plurality of carbon nanotubes (242, 342); and
a second flow channel (244-2) adjacent to the second number of the plurality of carbon nanotubes (242, 342).

4. The ultra-low temperature heat exchanger (124, 224, 324) of claim 3, wherein the first number of the plurality of carbon nanotubes (242, 342) and the second number of the plurality of carbon nanotubes (242, 342) are configured to exchange heat between an ultra-low temperature fluid in the first flow channel (244-1) and an ultra-low temperature fluid in the second flow channel (244-2).

5. The ultra-low temperature heat exchanger (124, 224, 324) of claim 1, wherein the superfluid is superfluid helium-4.

6. The ultra-low temperature heat exchanger (124, 224, 324) of claim 1, wherein the superfluid is superfluid helium-3.

7. The ultra-low temperature heat exchanger (124, 224, 324) of claim 1, wherein each respective carbon nanotube (242, 342) has a specific surface area of at least 1,000 meters-squared per gram (m²/g).

8. The ultra-low temperature heat exchanger (124, 224, 324) of claim 1, wherein each respective carbon nanotube (242, 342) comprises a non-metallic material.

9. The ultra-low temperature heat exchanger (124, 224, 324) of claim 8, wherein the non-metallic material is a carbon based non-metallic material.

10. The ultra-low temperature heat exchanger (124, 224, 324) of claim 1, wherein the substrate (240, 340) comprises a metal material.

11. A method of processing an ultra-low temperature heat exchanger (124, 224, 324), comprising:
forming a plurality of carbon nanotubes (242, 342) on a substrate (240, 340), wherein:
the plurality of carbon nanotubes (242, 342) are formed on the substrate (240, 340) such that there is a space (350) between each respective carbon nanotube (242, 342) into which a superfluid can wick; and
the plurality of carbon nanotubes (242, 342) are configured to exchange heat with the superfluid that wicks in the space (350) between each respective carbon nanotube (242, 342).

12. The method of claim 11, wherein forming the plurality of carbon nanotubes (242, 342) on the substrate (240, 340) includes forming the plurality of carbon nanotubes (242, 342) directly on the substrate (240, 340).

13. The method of claim 11, wherein forming the plurality of carbon nanotubes (242, 342) on the substrate (240, 340) includes:
forming a graphene material on the substrate (240, 340); and
forming the plurality of carbon nanotubes (242, 342) on the graphene material on the substrate (240, 340).

14. The method of claim 11, wherein the method includes:
sealing the ultra-low temperature heat exchanger (124, 224, 324) after forming the plurality of carbon nanotubes (242, 342) on the substrate (240, 340); and
installing the sealed heat exchanger (124, 224, 324) in a dilution refrigerator.

15. The method of claim 11, wherein the superfluid is a mixture of helium-3 and helium-4.
